# EUROPÄISCHE PATENTSCHRIFT

(11) **EP 0 870 070 B1**
(45) Veröffentlichungstag und Bekanntmachung des Hinweises auf die Patenterteilung: **31.05.2000**
(21) Anmeldenummer: 96946089.8
(22) Anmeldetag: 13.12.1996
(51) Int. Cl.: C23C 14/06, C23C 14/00, B65G 11/00

(54) **VERFAHREN ZUR HERSTELLUNG ORGANISCH MODIFIZIERTER OXID-, OXINITRID- ODER NITRIDSCHICHTEN DURCH VAKUUMBESCHICHTUNG**
PROCESS FOR PRODUCING ORGANICALLY MOFIFIED OXIDE, OXYNITRIDE OR NITRIDE LAYERS BY VACUUM DEPOSITION
PROCEDE DE PRODUCTION, PAR DEPOT SOUS VIDE, DE COUCHES D'OXYDE, D'OXYNITRURE OU DE NITRURE MODIFIEES DE MANIERE ORGANIQUE

(30) Priorität: 22.12.1995 DE 19548160
(43) Veröffentlichungstag der Anmeldung: 14.10.1998
(73) Patentinhaber: FRAUNHOFER-GESELLSCHAFT ZUR FÖRDERUNG DER ANGEWANDTEN FORSCHUNG E.V., 80636 München (DE)
(72) Erfinder: NEUMANN, Manfred, D-01217 Dresden (DE); SCHILLER, Siegfried, D-01324 Dresden (DE); MORGNER, Henry, D-01257 Dresden (DE); SCHILLER, Nicolas, D-01833 Helmsdorf (DE); STRAACH, Steffen, D-01187 Dresden (DE)
(86) Internationale Anmeldenummer: DE9602434
(87) Internationale Veröffentlichungsnummer: WO9723661

(56) Entgegenhaltungen:
- DE-A- 4 239 511
- FR-A- 2 683 230
- PATENT ABSTRACTS OF JAPAN vol. 006, no. 031 (C-092), 24.Februar 1982 & JP 56 147829 A (ASAHI GLASS CO LTD), 17.November 1981,
- NUCLEAR INSTRUMENTS AND METHODS IN PHYSICS RESEARCH, 1 JULY 1983, NETHERLANDS, Bd. 212, Nr. 1-3, ISSN 0167-5087, Seiten 497-503, XP002032591 BIEDERMAN H ET AL: "Metal doped fluorocarbon polymer films prepared by plasma polymerisation using an RF planar magnetron target"
- THIN SOLID FILMS, Bd. 269, Nr. 1/02, 15.November 1995, Seiten 6-13, XP000620380 KWAK B S ET AL: "DEPOSITION OF ORGANIC-INORGANIC COMPOSITE THIN FILMS BY LI3PO4 SPUTTERING AND C2H4 PLASMA POLYMERIZATION"

## Beschreibung

Die Erfindung betrifft ein Verfahren zur Herstellung organisch modifizierter Oxid-, Oxinitrid- oder Nitridschichten auf großen Flächen durch Vakuumbeschichtung und ein danach beschichtetes Substrat. Bevorzugte Anwendungen solcher Schichten sind transparente Barrierefolien für Verpackungen und transparente Korrosions- oder Abriebschutzschichten für Fensterflächen, Spiegel, dekorative Oberflächen oder Fassadenverkleidungen.

Es ist bekannt, Schichten für die genannten Anwendungen durch Lackierungen mit transparenten Lackschichten oder durch Aufkaschieren transparenter Kunststoffolien herzustellen. Damit wird zwar in vielen Fällen eine ausreichende Barriere- oder Korrosionsschutzwirkung, aber nur eine sehr geringe Abriebfestigkeit und für Anwendungen im Außenbereich eine ungenügende Witterungs- und UV-Stabilität erreicht.

Wesentlich höhere Abriebfestigkeiten und gute Barriere- und Korrosionsschutzeigenschaften bei wesentlich geringerem Materialaufwand werden durch Aufbringen transparenter Oxidschichten im Vakuum erreicht. Die Beschichtung erfolgt durch Bedampfungs-, Sputter- oder Plasma-CVD-Verfahren (G. Kienel: ,,Vakuumbeschichtung", Bd. 5, VDI-Verlag, Düsseldorf, 1993). Die auf diese Weise hergestellten anorganischen Oxidschichten besitzen jedoch eine sehr viel geringere Flexibilität als die durch Lackierung oder Kaschierung hergestellten organischen Beschichtungen. Dadurch werden die anfangs durch die Vakuumbeschichtung erreichten sehr guten Eigenschaften der Oxidschichten bei der Anwendung und Weiterverarbeitung der beschichteten Folien, Bleche oder Platten beeinträchtigt. Insbesondere ist ein nachträgliches Verstrecken oder Tiefziehen der beschichteten Materialien kaum möglich.

Es wurde bereits versucht, die hohe Flexibilität der organischen Beschichtungen mit der hohen Abriebfestigkeit und Witterungsstabilität der Oxidschichten zu kombinieren. Ein Beispiel sind sogenannte "organisch modifizierte Keramikschichten" ("ORMOCER"-Schichten), die nach dem Sol-Gel-Prozeß hergestellt und wie Lackschichten aufgetragen werden (R. Kasemann, H. Schmidt: New Journal of Chemistry, Vol. 18, 1994, Heft 10, Seite 1117). Sie erfordern jedoch ähnlich große Schichtdicken wie herkömmliche Lackschichten. Außerdem ist die Abriebfestigkeit und Witterungsbeständigkeit zwar besser als bei Lackschichten, aber bei weitem nicht so gut wie bei den im Vakuum aufgetragenen dünnen Oxidschichten.

Es ist weiterhin bekannt, organische Schichten mit anorganischem Oxidanteil dadurch herzustellen, daß die organischen Schichten mit Hilfe der Plasmapolymerisation im Vakuum abgeschieden werden, wobei als Monomer für die Plasmapolymerisation metallorganische oder siliziumorganische Dämpfe verwendet werden und durch gleichzeitigen Sauerstoffeinlaß auch Metalloxid- oder Siliziumoxidmoleküle gebildet und in die aufwachsende organische Polymerschicht eingelagert werden (JP 2/99933). Je nach verwendetem Monomer und je nach Sauerstoffanteil kann der Oxidanteil in der organischen Polymerschicht variiert werden. Auf diese Weise können mehr oder weniger harte Schichten abgeschieden werden, die sowohl gute Abriebfestigkeiten als auch gute Barriere- und Korrosionsschutz-Eigenschaften aufweisen. Dieses Verfahren hat jedoch den Nachteil, daß zum Erzielen qualitätsgerechter Schichten nur Abscheiderate von wenigen Nanometern pro Sekunde möglich sind. Damit ist dieses Verfahren für die ökonomische Beschichtung großer Flächen ungeeignet.

Es ist bekannt, auf einem Substrat zur Verbesserung der Gasundurchlässigkeit eine Schicht aus einer anorganischen und einer organischen Komponente aufzubringen, wobei die organische Komponente ungleichmäßig, im Monomer-Zustand in der Schicht verteilt ist (EP 0 470 777 A2). Der Nachteil besteht darin, daß die Schicht für die Weiterverarbeitung zu spröde ist, und daß die mit diesem Verfahren erzielten Bedampfungsraten zu gering sind.

Weiterhin ist ein Verfahren zur ionengestützten Vakuumbeschichtung bekannt, bei der ein Plasma zur Erzeugung von Ionen verwendet wird. Dabei werden zwischen Substrat und Beschichtungsquelle durch Anlegen von wechselweise positiven und negativen Spannungsimpulsen relativ zum Plasma Ionen zum Substrat beschleunigt (DE 44 12 906 C1). Nachteilig ist, daß die so erzeugten Schichten zu hart für eine anschließende Weiterverarbeitung des beschichteten Substrates sind.

Es ist bekannt, durch Simultanverdampfung von Polymeren und Metallen mit zwei Verdampferquellen Oxid-Polymer-Dispersionsschichten herzustellen (US 4,048,349). Dieses Verfahren ist jedoch sehr aufwendig, zumal eine anschließende Wärmbehandlung zur Oxidation durchgeführt werden muß.

Die Aufgabe der Erfindung besteht darin, ein Verfahren zur Herstellung organisch modifizierter Oxid-, Oxinitrid- oder Nitridschichten durch Vakuumbeschichtung zu schaffen, das die für die Beschichtung großer Flächen erforderlichen hohen Beschichtungsraten ermöglicht und mit dem Schichten abgeschieden werden können, die je nach Anwendungszweck gute Barriere-, Korrosions- oder Abriebschutzeigenschaften aufweisen und die außerdem eine solche Flexibilität besitzen, daß die guten Eigenschaften bei der Weiterverarbeitung und praktischen Verwendung in ausreichendem Maße erhalten bleiben. Es soll weiterhin über große Flächen eine hohe Homogenität erreicht werden. Eine weitere Aufgabe der Erfindung ist es, ein Substrat mit einer Beschichtung zu schaffen, welche die obengenannten Eigenschaften aufweist. Es sollen vorzugsweise band- und plattenförmige Substrate aus beliebigem Material sein.

Die Aufgabe wird nach den Merkmalen des Anspruches 1 gelöst. Vorteilhafte Ausgestaltungen des Verfahrens sind in den Ansprüchen 2 bis 12 beschrieben. Das erfindungsgemäße Substrat ist nach den Merkmalen des Anspruches 13 hergestellt. Vorteilhafte Ausgestaltungen desselben beschreiben die Ansprüche 14 bis 17.

Wesentlicher Ausgangspunkt des Verfahrens ist das an sich bekannte plasmagestützte reaktive Aufdampfen von Oxidschichten, mit dem die geforderten hohen Beschichtungsraten, die geforderte hohe Härte und Abriebfestigkeit der Schichten erreicht werden. Überraschender Weise wurde gefunden, daß durch zusätzliches Einlassen bereits geringer Mengen eines geeigneten Monomers in die Bedampfungszone eine unerwartet deutliche Modifizierung der ansonsten spröden Oxidschichten in Richtung auf eine höhere Flexibilität, d. h. eine höhere Dehnbarkeit und Biegsamkeit erfolgt. Weiterhin wird eine höhere Korrosionsschutzwirkung und eine bessere Barrierewirkung gegenüber der Diffusion von Gasen und Dämpfen erreicht. Eine wichtige Voraussetzung zur Erzielung dieser Effekte besteht darin, daß Reaktivgas und die Monomere in der Nähe des Substrates und mit Vorzugsrichtung auf die zu beschichtende Stelle des Substrates eingelassen werden und daß sie gemeinsam mit dem verdampften Oxid- bzw. Nitridbildner unmittelbar vor dem Auftreffen auf das Substrat eine hochdichte Plasmazone durchlaufen. Durch den Einlaß von Reaktivgas und Monomeren mit Vorzugsrichtung auf das Substrat werden unerwünschte Streueffekte minimiert und die gewünschten Anteile von Reaktivgas- und Monomermolekülen an der Substratoberfläche werden bereits bei relativ geringen Gasflüssen und Totaldrücken erreicht. Auf diese Weise wird eine höhere Packungsdichte der Schichtmoleküle erzielt. Von entscheidendem Einfluß auf die Schichtstruktur und die resultierenden Schichteigenschaften ist jedoch das Durchlaufen einer hochdichten Plasmazone vor dem Auftreffen auf das Substrat.

Hier werden sowohl die Moleküle und Atome des verdampften Oxid- bzw- Nitridbildners als auch die Reaktivgas- und Monomermoleküle so stark angeregt und teilweise ionisiert, daß sie in der aufwachsenden Schicht ein dichtes anorganisch-organisches Molekülnetzwerk ausbilden.

Der gleiche Effekt wird auch erzielt, wenn anstelle der oxid- bzw. nitridbildenden Elemente wie Silizium, Aluminium oder anderer reaktive Metalle, deren Oxide oder Suboxide verdampft werden, wobei dann die Menge des eingelassenen Reaktivgases reduziert werden kann. Diese Verfahrensweise ist dann von Vorteil, wenn die entsprechenden Oxide/Nitride oder Suboxide/Subnitride billiger als die oxid- bzw. nitridbildenden Elemente sind, wie das beim Siliziumdioxid (Quarz) im Vergleich zum Silizium der Fall ist. In den meisten Fällen, wie z. B. beim Aluminium, sind jedoch die Oxidbildner billiger und leichter verdampfbar als die entsprechenden Oxide oder Suboxide.

Für bestimmte Anwendungen kann es auch vorteilhaft sein, wenn die Schichteigenschaften sich über die Schichtdicke gradientenförmig verändern. Beispielsweise ist es für abriebfeste Schichten auf Kunststoffolien vorteilhaft, wenn die Härte der Schichten auf der substratzugewandten Seite geringer und damit dem Kunststoffsubstrat besser angepaßt ist, während an der substratabgewandten Schichtoberfläche eine hohe Härte erwünscht ist. Ein derartiger gradientenförmiger Schichtaufbau kann auch dadurch erreicht werden, daß die zu beschichtenden Substrate mit konstanter Geschwindigkeit über die Bedampfungszone bewegt werden und entweder der Reaktivgaseinlaß oder der Monomereinlaß oder der Schwerpunkt der Plasmazone nicht in der Mitte der Bedampfungszone sondern, bezogen auf die Bewegungsrichtung des Substrates, mehr am Anfang der Bedampfungszone oder mehr am Ende der Bedampfungszone angeordnet wird. Bei Anordnung am Anfang der Bedampfungszone wird mehr die substratzugewandte Seite der Schicht, bei Anordnung am Ende der Bedampfungszone wird mehr die substratabgewandte Seite der Schicht, d.h. die Schichtoberfläche, beeinflußt. Dabei führt ein höherer Reaktivgasanteil im allgemeinen zu einer erhöhten Transparenz und zu einer höheren Härte, aber oftmals auch zu einer geringeren Flexibilität der Schicht. Dagegen kann durch einen höheren Monomeranteil die Flexibilität der Schicht erhöht werden, während sich die Härte etwas verringert. Schließlich können durch Erhöhen der Plasmadichte die Härte und die Haftfestigkeit der Schichten erhöht und auch die Schichttransparenz beeinflußt werden. So können sowohl durch den Mittelwert als auch durch die örtliche Verteilung von Reaktivgas, Monomer und Plasmadichte sowohl der Mittelwert als auch der Gradient der Schichteigenschaften über die Schichtdicke in weiten Grenzen variiert werden. Die günstigsten Werte und die günstigste örtliche Verteilung ist je nach Anwendungsfall experimentell zu ermitteln.

An einem Ausführungsbeispiel wird das erfindungsgemäße Verfahren näher erläutert. Die zugehörige Zeichnung zeigt eine Einrichtung zur Durchführung des Verfahrens.

Das zu beschichtende Substrat 1 ist eine mit einer hoch reflektierenden Metallschicht versehene Kunststoffolie, die für großflächige Solar-Reflektoren in Solar-Kraftwerken eingesetzt werden soll und die eine hochtransparente, abriebfeste, korrosionsschützende und witterungsbeständige Schutzschicht benötigt. Das zu beschichtende Substrat 1 wird mit konstanter Geschwindigkeit von einer Abwickelrolle 2 über eine Kühlwalze 3 zu einer Aufwickelrolle 4 geführt. An der Unterseite der Kühlwalze 3 wird Aluminium als Oxidbildner aus einer Reihe widerstandsbeheizter Schiffchenverdampfer 5 verdampft. Für das Verdampfen anderer Oxidbildner wie Titan oder Zirkon bzw. für das Verdampfen von Oxiden oder Suboxiden wie SiO₂ oder SiO können anstelle der Schiffchenverdampfer 5 auch Elektronenstrahlverdampfer oder andere Hochrate-Verdampferquellen eingesetzt werden. Für die Erzeugung der hochdichten Plasmazone 6 unmittelbar vor dem Substrat werden zwei mit ca. 50 kHz bipolar gepulste Magnetrons 7 verwendet. Unterhalb der Plasmazone 6 sind zwei Düsenrohre 8; 9 zum Einlassen des Reaktivgases Sauerstoff und zwei Düsenrohre 10; 11 zum Einlassen des Monomers Hexamethyldisiloxan (HMDSO) vorgesehen. Die Düsenrohre 8; 9; 10; 11 sind auf die zu beschichtende Stelle des Substrates 1 gerichtet, um eine gute Reaktivgas- und Monomerausnutzung und einen möglichst geringen Druck in der Beschichtungskammer zu gewährleisten.

Nach Einstellen der gewünschten Aluminium-Verdampfungsrate mit Hilfe der Schiffchenverdampfer 5 und der durch Vorversuche ermittelten optimalen Plasmadichte in der Plasmazone 6 wird der Sauerstofffluß über die Düsenrohre 8 und 9 zu gleichen Anteilen so lange erhöht, bis eine Aluminiumoxidschicht mit der erforderlichen hohen Transparenz erzielt wird. Die Transparenz der abgeschiedenen Schicht wird über ein Reflexionsspektrometer 12 gemessen. Danach wird der Monomerfluß über die Düsenrohre 10 und 11 auf den durch Vorversuche ermittelten optimalen Wert eingestellt, wobei es im allgemeinen zweckmäßig ist, den Fluß durch das Düsenrohr 10 höher als den Fluß durch das Düsenrohr 11 einzustellen. Die durch den Monomereinlaß oftmals auftretende Transparenzverringerung der abgeschiedenen Schicht kann durch weiteren Sauerstoffeinlaß weitgehend kompensiert werden. Im Interesse einer hohen Oberflächenhärte der Schicht ist es zweckmäßig, diesen zusätzlichen Sauerstoff-einlaß im wesentlichen durch das Düsenrohr 9 vorzunehmen.

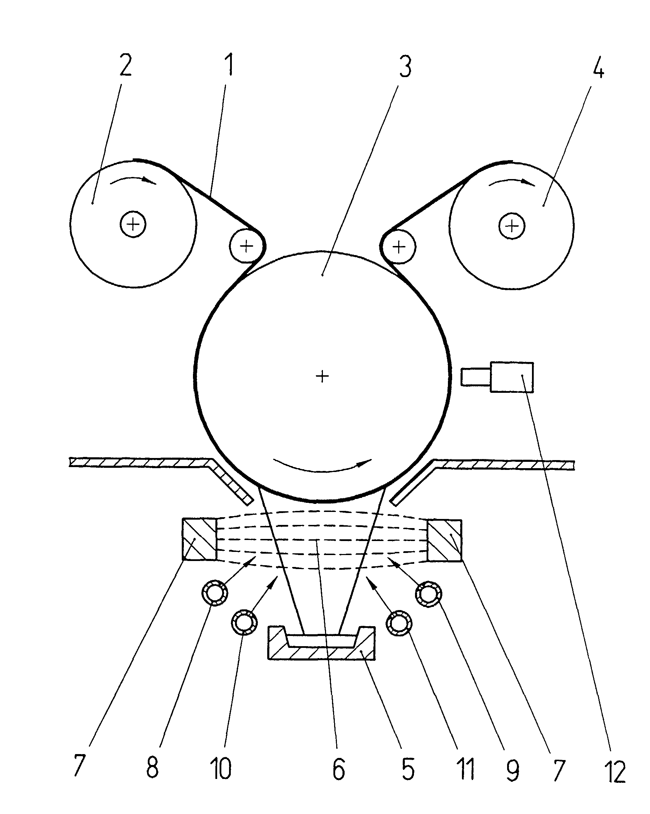

## Patentansprüche

1. Verfahren zur Herstellung organisch modifizierter Oxid-, Oxinitrid- oder Nitridschichten durch Vakuumbeschichtung auf einem Substrat durch plasmagestützte Verdampfung eines oxid- und nitridbildenden Verdampfungsmaterials, **dadurch gekennzeichnet,** daß die Schichten durch plasmagestützte, reaktive Hochrateverdampfung des Verdampfungsmaterials unter Zuführung mindestens eines der Reaktivgase Sauerstoff und Stickstoff sowie zusätzlich gasförmige Monomere mit einer Vorzugsrichtung auf das zu beschichtende Substrat in die Bedampfungszone und Durchlaufen einer hochdichten Plasmazone mit einer Plasmadichte von mindestens 10⁹ cm⁻³ unmittelbar vor dem Substrat abgeschieden werden.

2. Verfahren nach Anspruch 1, **dadurch gekennzeichnet,** daß die Schichten mit Beschichtungsraten von mindestens 10 nm/s, vorzugsweise von 20 bis 1000 nm/s abgeschieden werden.

3. Verfahren nach den Ansprüchen 1 und 2, **dadurch gekennzeichnet,** daß vor dem Substrat eine Plasmadichte von 10¹⁰ bis 10¹² cm⁻³ eingestellt wird.

4. Verfahren nach den Ansprüchen 1 bis 3, **dadurch gekennzeichnet,** daß die plasmagestützte reaktive Hochrateverdampfung unter Verwendung einer diffusen Bogenentladung, einer gepulsten oder nichtgepulsten Magnetronentladung oder einer ECR-Mikrowellenentladung durchgeführt wird.

5. Verfahren nach den Ansprüchen 1 bis 4, **dadurch gekennzeichnet**, daß als Verdampfungsmaterial Silizium, Aluminium, ein anderes Metall oder eine Metallegierung verwendet wird.

6. Verfahren nach den Ansprüchen 1 bis 5, **dadurch gekennzeichnet,** daß anstelle des Oxidbildners das abzuscheidende Oxid selbst oder ein Suboxid verdampft werden, wobei der Anteil des eingelassenen Sauerstoffs reduziert wird.

7. Verfahren nach Anspruch 6, **dadurch gekennzeichnet,** daß anstelle von Silizium, Siliziumdioxid oder Siliziummonoxid verdampft wird.

8. Verfahren nach den Ansprüchen 1 bis 7, **dadurch gekennzeichnet,** daß als gasförmige Monomere polymerisierbare Kohlenwasserstoffe, metallorganische Verbindungen, siliziumorganische Verbindungen, fluororganische Verbindungen oder deren Mischungen eingelassen werden.

9. Verfahren nach den Ansprüchen 1 bis 8, **dadurch gekennzeichnet,** daß das zu beschichtende Substrat gleichförmig über die Bedampfungszone bewegt wird.

10. Verfahren nach Anspruch 9, **dadurch gekennzeichnet**, daß das Reaktivgas, bezogen auf die Bewegungsrichtung des Substrates, am Anfang, in der Mitte oder am Ende der Bedampfungszone eingelassen wird.

11. Verfahren nach den Ansprüchen 9 und 10, **dadurch gekennzeichnet,** daß die gasförmigen Monomere, bezogen auf die Bewegungsrichtung des Substrates, am Anfang, in der Mitte oder am Ende der Bedampfungszone eingelassen werden.

12. Verfahren nach den Ansprüchen 9 bis 11, **dadurch gekennzeichnet,** daß die hochdichte Plasmazone, bezogen auf die Bewegungsrichtung des Substrates, derart ausgedehnt wird, daß sie sich am Anfang oder am Ende der Bedampfungszone befindet oder annähernd über die gesamte Bedampfungszone erstreckt.

13. Substrat mit einer organisch modifizierten Oxid-, Oxinitrid- oder Nitridschicht, nach dem Verfahren gemäß Anspruch 1 hergestellt, **dadurch gekennzeichnet,** daß die durch plasmagestützte Hochratebedampfung aufgebrachte Schicht zu mehr als 50 Gewichtsprozenten, vorzugsweise zu mehr als 80 Gewichtsprozenten, aus anorganischen Molekülen und zu weniger als 50 Gewichtsprozenten, vorzugsweise zu weniger als 20 Gewichtsprozenten, aus teilweise vernetzten organischen Molekülen besteht.

14. Substrat nach Anspruch 13, **dadurch gekennzeichnet,** daß die anorganischen Moleküle Oxide, Oxinitride oder Nitride von Silizium, Aluminium oder anderen Metallen sind.

15. Substrat nach Anspruch 13 und 14, **dadurch gekennzeichnet,** daß die teilweise vernetzten organischen Moleküle Kohlenstoff, Silizium, Metall und/oder Fluor enthalten.

16. Substrat nach Anspruch 13 bis 15, **dadurch gekennzeichnet,** daß der Anteil der organischen Moleküle von der substratzugewandten Seite zur substratabgewandten Seite der Schicht abnimmt.

17. Substrat nach Anspruch 13 bis 16, **dadurch gekennzeichnet,** daß der Sauerstoff- und/oder Stickstoffanteil der Schicht von der substratzugewandten Seite zur substratabgewandten Seite der Schicht zunimmt.

## Claims

1. A process for producing organically modified oxide, oxynitride or nitride coatings by vacuum deposition on a substrate through plasma-assisted vaporisation of an oxide and nitride forming vaporisation material, characterized in that the coatings are deposited by plasma-assisted, reactive, high rate vaporisation of the vaporisation material with introduction of at least one of the reactive gases oxygen and nitrogen as well as additional gaseous monomers with a preferred direction on to the substrate to be coated in the vapour deposition zone and passage through a high density plasma zone with a plasma density of at least 10⁹ cm⁻³ directly in front of the substrate.

2. A process according to claim 1, characterized in that the coatings are deposited at coating rates of at least 10 nm/s, preferably from 20 to 1000 nm/s.

3. A process according to claims 1 and 2, characterized in that a plasma density in front of the substrate is set from 10¹⁰ to 10¹² cm⁻³.

4. A process according to claims I to 3, characterized in that the plasma-assisted, reactive, high-rate vaporisation is effected using a diffuse arc discharge, a pulsed or non-pulsed magnetron discharge or an ECR microwave discharge.

5. A process according to claims 1 to 4, characterized in that silicon, aluminium, another metal or a metal alloy is used as the vaporisation material.

6. A process according to claims 1 to 5, characterized in that, instead of the oxide former, the oxide to be deposited itself or a sub-oxide is vaporised, while the proportion of the oxygen introduced is reduced.

7. A process according to claim 6, characterized in that silicon dioxide or silicon monoxide is vaporised instead of silicon.

8. A process according to claims 1 to 7, characterized in that polymerisable hydrocarbons, organo-metallic compounds, silicon-organic compounds, fluoro-organic compounds or their mixtures are introduced as gaseous monomers.

9. A process according to claims 1 to 8, characterized in that the substrate to be coated is moved uniformly over the vapour deposition zone.

10. A process according to claim 9, characterized in that the reactive gas is introduced, relative to the direction of movement of the substrate, at the start, in the middle or at the end of the vapour deposition zone.

11. A process according to claims 9 and 10, characterized in that the gaseous monomers are introduced, relative to the direction of movement of the substrate, at the start, in the middle or at the end of the vapour deposition zone.

12. A process according to claims 9 to 11, characterized in that the high density plasma zone is so extended relative to the direction of movement of the substrate that it is located at the start or at the end of the vapour deposition zone or extends approximately over the whole vapour deposition zone.

13. A substrate with an organically-modified oxide, oxynitride or nitride coating, produced according to the process according to claim 1, characterized in that the coating applied by plasma-assisted, high rate vapour deposition consists of more than 50 weight percent, preferably more than 80 weight percent, of inorganic molecules, and of less than 50 weight percent, preferably less than 20 weight percent of partially cross-linked organic molecules.

14. A substrate according to claim 13, characterized in that the inorganic molecules are oxides, oxynitrides or nitrides of silicon, aluminium or other metals.

15. A substrate according to claim 13 and 14, characterized in that the partially cross-linked organic molecules contain carbon, silicon, metal and/or fluorine.

16. A substrate according to claim 13 to 15, characterized in that the proportion of the organic molecules falls off from the side of the coating facing the substrate to the side facing away from the substrate.

17. A substrate according to claim 13 to 16, characterized in that the oxygen and/or nitrogen proportion of the coating increases from the side of the coating facing the substrate to the side facing away from the substrate.

## Revendications

1. Procédé de production par dépôt sous vide de couches d'oxyde, d'oxynitrure ou de nitrure, modifiées de manière organique, sur un substrat, par vaporisation assistée par plasma d'un matériau d'évaporation générateur d'oxydes et de nitrures,
caractérisé en ce que
les couches sont déposées par évaporation réactive à débit élevé, assistée par plasma, du matériau d'évaporation, avec apport au moins de l'un des gaz réactifs que sont l'oxygène et l'azote, ainsi que, en plus, des monomères se présentant sous forme gazeuse avec une direction préférentielle sur le substrat à revêtir dans la zone d'évaporation, et traversée d'une zone de plasma à haute densité, d'une densité de plasma d'au moins 10⁹ cm⁻³ directement avant le substrat.

2. Procédé selon la revendication 1,
caractérisé en ce que
les couches sont déposées à des vitesses de revêtement d'au moins 10 nm/s, de préférence de 20 à 1000 nm/s.

3. Procédé selon les revendications 1 et 2,
caractérisé en ce que
devant le substrat est réglée une densité de plasma de 10¹⁰ à 10¹² cm⁻³.

4. Procédé selon les revendications 1 à 3,
caractérisé en ce que
l'évaporation réactive à haute vitesse, assistée par plasma, est effectuée sous utilisation d'une décharge en arc, une décharge à magnétron, pulsée ou non pulsée, ou une décharge à micro-ondes ECR.

5. Procédé selon les revendications 1 à 4,
caractérisé en ce qu'
on utilise comme matériau d'évaporation le silicium, l'aluminium, un autre métal ou un alliage de métaux.

6. Procédé selon les revendications 1 à 5,
caractérisé en ce qu'
au lieu du formateur d'oxyde, on évapore l'oxyde à déposer lui-même ou bien un sous-oxyde, la proportion d'oxyde introduite étant réduite.

7. Procédé selon la revendication 6,
caractérisé en ce qu'
au lieu de silicium, on évapore du dioxyde de silicium ou du monoxyde de silicium.

8. Procédé selon les revendications 1 à 7,
caractérisé en ce qu'
on introduit comme monomère se présentant sous forme gazeuse des hydrocarbures polymérisables, des combinaisons organométalliques, des combinaisons organosiliciques, des combinaisons organofluorées ou bien leurs mélanges.

9. Procédé selon les revendications 1 à 8,
caractérisé en ce que
le substrat à revêtir est déplacé uniformément sur la zone d'évaporation.

10. Procédé selon la revendication 9,
caractérisé en ce que
le gaz réactif, en se référant à la direction de déplacement du substrat, est introduit au début, au centre ou à la fin de la zone d'évaporation.

11. Procédé selon les revendications 9 et 10,
caractérisé en ce que
les monomères se présentant sous forme gazeuse, en se référant à la direction de déplacement du substrat, sont introduits au début, au centre ou à la fin de la zone d'évaporation.

12. Procédé selon les revendications 9 à 11,
caractérisé en ce que
la zone de plasma à haute densité, en se référant à la direction de déplacement du substrat, est étendue de manière qu'elle se trouve au début ou à la fin de la zone d'évaporation, ou qu'elle s'étende à peu près sur la totalité de la zone d'évaporation.

13. Substrat avec une couche d'oxyde, d'oxynitrure, ou de nitrure, modifiée de manière organique, fabriquée suivant le procédé selon la revendication 1,
caractérisé en ce que
la couche appliquée par une évaporation à haut débit, assistée par plasma, est constituée, pour plus de 50 % en poids, de préférence pour plus de 80 % en poids, de molécules organiques et, pour moins de 50 % en poids, de préférence pour moins de 20 % en poids, de molécules organiques partiellement réticulées.

14. Substrat selon la revendication 13,
caractérisé en ce que
les molécules non organiques sont des oxydes, des oxynitrures ou des nitrures, du silicium, de l'aluminium ou d'autres métaux.

15. Substrat selon les revendications 13 et 14,
caractérisé en ce que
les molécules organiques partiellement réticulées contiennent du carbone, du silicium, un métal et/ou du fluor.

16. Substrat selon les revendications 13 à 15,
caractérisé en ce que
la proportion de molécules organiques va en diminuant, en allant du côté tourné vers le substrat vers le côté, opposé au substrat, de la couche.

17. Substrat selon les revendications 13 à 16,
caractérisé en ce que
la proportion d'oxygène et/ou d'azote de la couche va en augmentant, en allant du côté tourné vers le substrat vers le côté, opposé au substrat, de la couche.
